# EUROPEAN PATENT APPLICATION

(11) **EP 4 761 475 A1**
(43) Date of publication of application: **17.06.2026**
(21) Application number: 25221073.7
(22) Date of filing: 05.12.2025
(51) Int. Cl.: H05K 1/185, H10W 70/60, H05K 3/46

(54) **OFFSET-CHIP EMBEDDED CIRCUIT BOARD AND MANUFACTURING METHOD THEREFOR**

(30) Priority: 10.12.2024 CN 202411807585
(71) Applicant: ZF Friedrichshafen AG, 88046 Friedrichshafen (DE)
(72) Inventor: XU, Qing, Shanghai, 201615 (CN); YUAN, Shaozhi, Shanghai, 201615 (CN)

(57) **Abstract**

The present disclosure relates to the technical field of automotive parts, and provides an offset-chip embedded circuit board and a manufacture method therefor. The offset-chip embedded circuit board includes: a core; a chip packaging unit embedded in the core, the chip packaging unit including a conductive substrate and a chip unit embedded in the conductive substrate, wherein the chip unit is offset on a side of the conductive substrate, and an electrode lead-out area of the chip unit is reserved on the other side of the conductive substrate; a prepreg and a conductive layer stacked on the core; and lead-out wires led out from a front side of the chip packaging unit and arranged in the prepreg and the conductive layer. In the present disclosure, the chip unit is offset on a side of the conductive substrate, and the electrode lead-out area of the chip unit is reserved on the other side of the conductive substrate, such that during the formation of the offset-chip embedded circuit board, lead-out wires of electrodes of the chip unit can all be led out from the front side of the chip packaging unit, facilitating wiring.

## Description

### TECHNICAL FIELD

The present disclosure relates to the technical field of automotive parts, and particularly, to an offset-chip embedded circuit board and a manufacture method therefor.

### BACKGROUND ART

In automotive parts such as inverters, a widely used chip packaging structure is a chip embedded packaging structure, namely, a chip is embedded in a busbar. A chip structure used therein has a gate and a source located on a front side and a drain on a back side. The drain lead-out is implemented by the busbar.

In the current design, after the chip is embedded in the busbar, a small area remains on a front side of the busbar, making it inconvenient to lead out the drain, so the drain of the chip needs to be led out from a back side of the busbar. In automotive parts such as inverters, a drain of a chip needs to be connected to a source of another chip. The source is led out from the front side, and the drain is led out from the back side, causing inconvenience for wiring.

It should be noted that information disclosed in the above background art section is only used to enhance the understanding of the background of the present disclosure, and therefore may include information that does not constitute the prior art known to those of ordinary skill in the art.

### SUMMARY

In view of this, the present disclosure provides an offset-chip embedded circuit board and a manufacturing method thereof. A chip unit is offset on a side of a conductive substrate, and an electrode lead-out area of the chip unit is reserved on the other side of the conductive substrate, such that during the formation of the offset-chip embedded circuit board, lead-out wires of electrodes of the chip unit can all be led out from a front side of a chip packaging unit, facilitating wiring.

According to one aspect of the present disclosure, an offset-chip embedded circuit board is provided, including: a core; a chip packaging unit embedded in the core, the chip packaging unit including a conductive substrate and a chip unit embedded in the conductive substrate, wherein the chip unit is offset on a side of the conductive substrate, and an electrode lead-out area of the chip unit is reserved on the other side of the conductive substrate; a prepreg and a conductive layer stacked on the core; and lead-out wires led out from a front side of the chip packaging unit and arranged in the prepreg and the conductive layer.

In some embodiments, a gate lead-out area, a source lead-out area, and a drain lead-out area of the chip unit are all distributed on the front side of the chip packaging unit; and the lead-out wires include gate lead-out wires connected to the gate lead-out area, source lead-out wires connected to the source lead-out area, and drain lead-out wires connected to the drain lead-out area.

In some embodiments, a gate and a source of the chip unit are located on a front side of the chip unit, and a drain of the chip unit is located on a back side of the chip unit; and the electrode lead-out area reserved on the conductive substrate is the drain lead-out area, and the gate lead-out area and the source lead-out area are located on the chip unit.

In some embodiments, an effective area of the drain lead-out area matches an effective area of the source lead-out area.

In some embodiments, the source lead-out wires and the drain lead-out wires are both arranged in a grid-like manner.

In some embodiments, the offset-chip embedded circuit board further includes: pads disposed on the conductive layer and electrically connected to the lead-out wires.

In some embodiments, an entire upper surface of the offset-chip embedded circuit board forms a drive circuit arrangement area.

In some embodiments, the chip packaging unit is a power module of an inverter; and a plurality of chip units are embedded in the core, wherein a drain lead-out wire of a chip unit of an upper bridge arm is connected to a positive electrode of a power source, a source lead-out wire of a chip unit of a lower bridge arm is connected to a negative electrode of the power source, a source lead-out wire of the chip unit of the upper bridge arm is connected to a drain lead-out wire of the chip unit of the lower bridge arm and to a winding of an electric motor, and a gate lead-out wire of the chip unit of the upper bridge arm and the drain lead-out wire of the chip unit of the lower bridge arm are connected to a drive circuit arranged on the upper surface of the embedded circuit board.

According to another aspect of the present disclosure, there is provided a manufacturing method for a circuit board for manufacturing an offset-chip embedded circuit board according to any one of the above embodiments, the manufacturing method including: forming a slot in a core; embedding a chip packaging unit in the slot, the chip packaging unit comprising a conductive substrate and a chip unit embedded in the conductive substrate, wherein the chip unit is offset on a side of the conductive substrate, and an electrode lead-out area of the chip unit is reserved on the other side of the conductive substrate; stacking a prepreg and a conductive layer on the core, and drilling the conductive layer and the prepreg to form vias that penetrate the conductive layer and the prepreg and that communicate with lead-out areas of electrodes of the chip unit; and filling a conductive material into the vias to form lead-out wires that are led out from a front side of the chip packaging unit and arranged in the prepreg and the conductive layer.

In some embodiments, prepregs and conductive layers are alternately stacked in a plurality of groups; and stacking a prepreg and a conductive layer on the core and drilling the conductive layer and the prepreg includes: stacking a first prepreg and a first conductive layer on the core, and drilling the first conductive layer and the first prepreg to form first vias that penetrate the first conductive layer and the first prepreg and that communicate with the lead-out areas of the electrodes of the chip unit; and stacking a second prepreg and a second conductive layer on the first conductive layer, and drilling the second conductive layer and the second prepreg to form second vias that penetrate the second conductive layer and the second prepreg and that communicate with the lead-out areas of the electrodes of the chip unit through the first vias.

Compared with the prior art, the present disclosure has at least the following beneficial effects.

In the present disclosure, the chip unit is offset on a side of the conductive substrate, and the electrode lead-out area of the chip unit is reserved on the other side of the conductive substrate, such that during the formation of the offset-chip embedded circuit board, lead-out wires of electrodes of the chip unit can all be led out from the front side of the chip packaging unit, facilitating the arrangement of the lead-out wires and wiring between the lead-out wires.

In addition, in the present disclosure, the chip packaging unit is embedded in the core of the circuit board, and laminated at the bottom of the circuit board, such that structures such as the prepreg and the conductive layer of the circuit board can be used as an insulation layer and a conductor layer for arranging the lead-out wires, and a drive circuit arrangement area is reserved on an upper surface of the circuit board to provide space for the arrangement of a drive circuit, such that the formed offset-chip embedded circuit board has a compact overall structure and stable performance, and the consumable cost is significantly reduced.

It should be understood that the above general description and the following detailed description are only exemplary and explanatory, and cannot limit the present disclosure.

### BRIEF DESCRIPTION OF THE DRAWINGS

The accompanying drawings herein, which are incorporated into and form a part of the description, illustrate embodiments consistent with the present disclosure and, together with the description, are used to explain principles of the present disclosure. Obviously, the accompanying drawings described below show merely some of the embodiments of the present disclosure, and those of ordinary skill in the art would also have obtained other accompanying drawings according to these accompanying drawings without any creative effort.
Fig. 1 shows a schematic cross-sectional structural view of an offset-chip embedded circuit board according to an embodiment of the present disclosure;
Fig. 2 shows a schematic perspective structural view of a chip packaging unit according to an embodiment of the present disclosure;
Fig. 3 shows a schematic explored structural diagram of a chip packaging unit according to an embodiment of the present disclosure; and
Fig. 4 shows a schematic diagram of steps of a manufacturing method for an offset-chip embedded circuit board according to an embodiment of the present disclosure.

### DETAILED DESCRIPTION OF EMBODIMENTS

Now exemplary implementations will be described more fully with reference to the accompanying drawings. However, the exemplary implementations can be implemented in many forms and should not be construed as being limited to the implementations described herein. On the contrary, these implementations are provided to make the present disclosure more thorough and complete, and to fully convey the concept of the exemplary implementations to those skilled in the art.

The accompanying drawings are only schematic illustrations of the present disclosure, and are not necessarily drawn to scale. In the accompanying drawings, the same reference numerals denote the same or similar parts, and thus the repeated description thereof will be omitted. The processes shown in the accompanying drawings are only exemplary illustrations, and do not necessarily include all steps. For example, some steps can be divided, and some steps can be combined or partially combined, and the actual execution order thereof may be changed based on actual conditions.

The terms "first", "second" and similar terms used in the specific description do not denote any order, quantity, or importance, but are merely used to distinguish between different components. Orientations or positional relationships indicated by the terms such as "upper", "lower", "front" and "rear" are based on orientations or positional relationships shown in the drawings, which is only for convenience of describing the present disclosure and simplifying the description, rather than indicating or implying that an apparatus or an element referred to must have a specific orientation or be constructed and operated in a specific orientation, and therefore cannot be construed as limiting the present disclosure. The term "a plurality of" means two or more, unless otherwise explicitly and specifically defined. Moreover, in the description of the disclosure, when it is said that a device is "connected" to another device, this includes not only the case of direct connection but also the case of indirect connection through other elements.

It should be noted that the embodiments in the present disclosure and features of the various embodiments can be combined with each other without conflict.

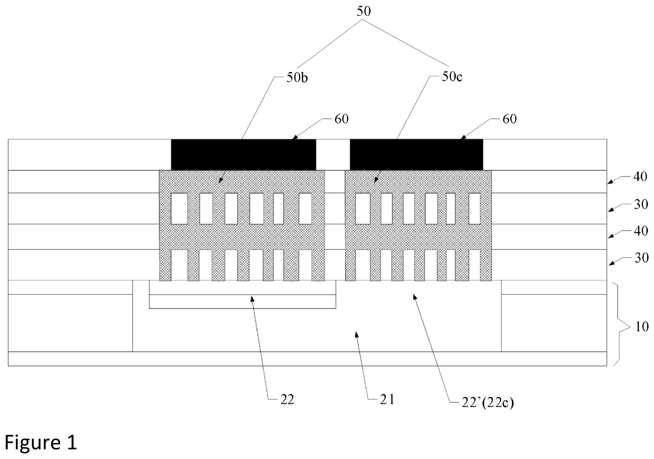

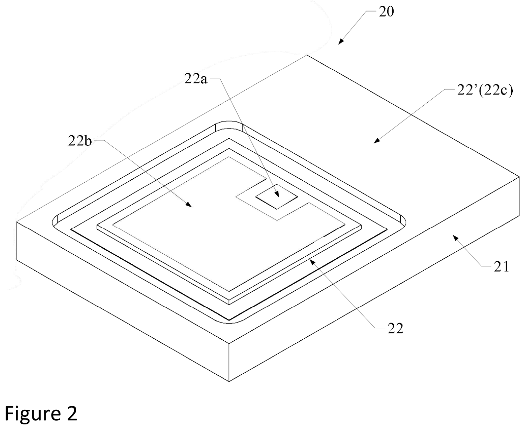

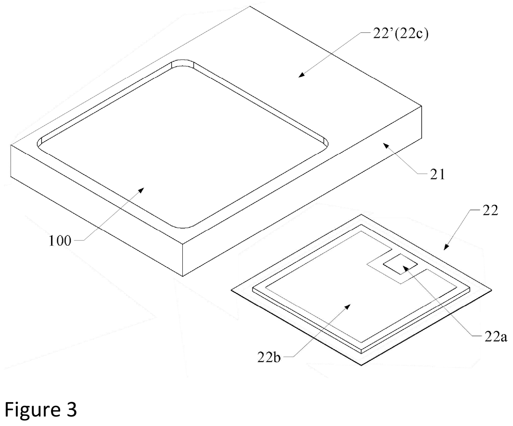

Fig. 1 illustrates a cross-sectional structural view of an offset-chip embedded circuit board. Fig. 2 illustrates a schematic perspective structural view of a chip packaging unit. Fig. 3 illustrates a schematic explored structural diagram of a chip packaging unit according to an embodiment of the present disclosure. With reference to Figs. 1 to 3, an offset-chip embedded circuit board according to an embodiment of the present disclosure includes:
a core 10;
a chip packaging unit 20 embedded in the core 10, the chip packaging unit 20 including a conductive substrate 21 and a chip unit 22 embedded in the conductive substrate 21, wherein
the chip unit 22 is offset on a side of the conductive substrate 21, and an electrode lead-out area 22' of the chip unit 22 is reserved on the other side of the conductive substrate 21;
a prepreg 30 and a conductive layer 40 stacked on the core 10; and
lead-out wires 50 led out from a front side of the chip packaging unit 20 and arranged in the prepreg 30 and the conductive layer 40.

The core 10 is a base material of the circuit board, and includes an intermediate layer of sheet material having a certain hardness and thickness is coated with copper foils on both sides thereof. The prepreg 30 is a semi-solid material, and serves the functions of bonding and insulation. The conductive layer 40 is, for example, a metal layer such as a copper layer.

In the present disclosure, the chip unit 22 is offset on a side of the conductive substrate 21, and the electrode lead-out area 22' of the chip unit 22 is reserved on the other side of the conductive substrate 21, such that during the formation of the offset-chip embedded circuit board, lead-out wires 50 of electrodes of the chip unit 22 can all be led out from the front side of the chip packaging unit 20, facilitating the arrangement of the lead-out wires 50 and wiring between the lead-out wires 50.

In addition, in the present disclosure, the chip packaging unit 20 is embedded in the core 10 of the circuit board, and laminated at the bottom of the circuit board, such that structures such as the prepreg 30 and the conductive layer 40 of the circuit board can be used as an insulation layer and a conductor layer for arranging the lead-out wires 50, and a drive circuit arrangement area is reserved on an upper surface of the circuit board to provide space for the arrangement of a drive circuit, such that the formed offset-chip embedded circuit board has a compact overall structure and stable performance, and the consumable cost is significantly reduced.

In some embodiments, a gate lead-out area 22a, a source lead-out area 22b and a drain lead-out area 22c of the chip unit 22 are all distributed on the front side of the chip packaging unit 20; and the lead-out wires 50 include gate lead-out wires (not specifically shown) connected to the gate lead-out area 22a, source lead-out wires 50b connected to the source lead-out area 22b, and drain lead-out wires 50c connected to the drain lead-out area 22c.

This facilitates the wiring of the electrodes of the chip unit 22, allowing all the lead-out wires 50 to be led out from the front side of the chip packaging unit 20. In this way, on the one hand, the lead-out wires do not need to be routed from a back side, thus simplifying the wiring process. On the other hand, after the chip packaging unit 20 is embedded in the core 10, the prepreg 30 and the conductive layer 40 are further stacked on the core 10. The prepreg 30 and the conductive layer 40 of the circuit board may be used as an insulation layer and a conductive layer for the arrangement of the lead-out wires 50, eliminating the need of additionally providing functional film layers. Thus, the compactness of the offset-chip embedded circuit board is improved, and cost-effectiveness is increased. Furthermore, problems caused by drain currents flowing from bottom to top can be avoided, thereby reducing parasitic reluctance and improving EMC performance.

In some embodiments, a gate and a source of the chip unit 22 are located on a front side of the chip unit 22, and a drain of the chip unit 22 is located on a back side of the chip unit 22; and the electrode lead-out area 22' reserved on the conductive substrate 21 is the drain lead-out area 22c, and the gate lead-out area 22a and the source lead-out area 22b are located on the chip unit 22.

In this embodiment, the drain of the chip unit 22 is located on the back side of the chip unit 22; and to facilitate drain lead-out, the drain lead-out area 22c is reserved on the conductive substrate 21. In other embodiments, the positions of the gate/source/drain of the chip unit 22 may vary depending on the chip design. For the cases where the areas of gate/source/drain areas of the chip unit 22 are too small, causing inconvenient lead-out, the gate/source/drain are distributed on the front and back sides of the chip unit 22, causing inconvenient wiring, etc., the solution of the present disclosure may be used in which the chip unit 22 is offset on a side of the conductive substrate 21, and the electrode lead-out area 22' of the chip unit 22 is reserved on the other side of the conductive substrate 21, such that during the manufacturing of the circuit board, the lead-out wires 50 of the electrodes of the chip unit 22 can all be led out from the front side of the chip packaging unit 20, facilitating the arrangement of the lead-out wires 50 and wiring between the lead-out wires 50.

In some embodiments, an effective area of the drain lead-out area 22c matches an effective area of the source lead-out area 22b.

The effective area refers to an area available for wiring, for example, an area excluding edge portions. The effective areas matching each other may mean that they are equal or approximately equal. The effective area of the drain lead-out area 22c match the effective area of the source lead-out area 22b to facilitate wiring between the source and the drain of the chip unit 22.

In some embodiments, the source lead-out wires 50b and the drain lead-out wires 50c are both arranged in a grid-like manner.

The grid-like source lead-out wires 50b and drain lead-out wires 50c can carry large currents, thereby improving current sharing between circuits, mitigating thermal expansion, and enhancing stability in applications such as inverters.

In some embodiments, the offset-chip embedded circuit board further includes: pads 60 disposed on the conductive layer 40 and electrically connected to the lead-out wires 50. The pads 60 facilitate electrical connections of the lead-out wires 50 and the drive circuit arranged on the upper surface of the offset-chip embedded circuit board.

In some embodiments, the entire upper surface of the offset-chip embedded circuit board forms a drive circuit arrangement area. Specifically, a film structure such as a shielding layer/insulation buffer layer may first be provided on the pads 60, followed by the arrangement of the drive circuit and the electrical connections between the drive circuit and the pads 60. In the present disclosure, the chip packaging unit 20 is embedded in the circuit board, and the drive circuit arrangement area is reserved on the upper surface of the circuit board to provide space for the arrangement of the drive circuit, such that the formed offset-chip embedded circuit board has a compact overall structure and stable performance.

In some embodiments, the chip packaging unit 20 is a power module of an inverter; and a plurality of chip units 22 are embedded in the core 10, wherein a drain lead-out wire 50c of a chip unit 22 of an upper bridge arm is connected to a positive electrode of a power source, a source lead-out wire 50b of a chip unit 22 of a lower bridge arm is connected to a negative electrode of the power source, a source lead-out wire 50b of the chip unit 22 of the upper bridge arm is connected to a drain lead-out wire 50c of the chip unit 22 of the lower bridge arm and to a winding of an electric motor, and a gate lead-out wire of the chip unit 22 of the upper bridge arm and the drain lead-out wire of the chip unit of the lower bridge arm are connected to the drive circuit arranged on the upper surface of the offset-chip embedded circuit board.

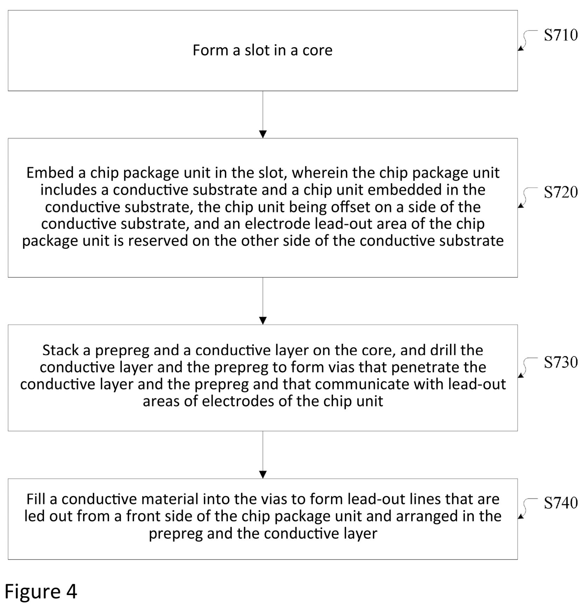

An embodiment of the present disclosure further provides a manufacturing method for a circuit board, for manufacturing an offset-chip embedded circuit board according to any one of the above embodiments. Fig. 4 illustrates main steps of a manufacturing method for an offset-chip embedded circuit board. With reference to Figs. 1 to 4, a manufacturing method for a circuit board according to an embodiment of the present disclosure includes the following steps.

In step S710, a slot 100 is formed in a core 10.

In step S720, a chip packaging unit 20 is embedded in the slot, wherein the chip packaging unit 20 includes a conductive substrate 21 and a chip unit 22 embedded in the conductive substrate 21, with the chip unit 22 being offset on a side of the conductive substrate 21, and an electrode lead-out area 22' of the chip packaging unit 20 being reserved on the other side of the conductive substrate 21.

In the present disclosure, the chip unit 22 is offset on a side of the conductive substrate 21, and the electrode lead-out area 22' of the chip unit 22 is reserved on the other side of the conductive substrate 21, such that during the formation of the offset-chip embedded circuit board, lead-out wires 50 of electrodes of the chip unit 22 can all be led out from the front side of the chip packaging unit 20, facilitating the arrangement of the lead-out wires 50 and wiring between the lead-out wires 50.

In step S730, a prepreg 30 and a conductive layer 40 are stacked on the core 10, and the conductive layer 40 and the prepreg 30 are drilled to form vias that penetrate the conductive layer 40 and the prepreg 30 and communicate with lead-out areas of electrodes of the chip unit 22.

The vias may be formed by laser drilling.

In step S740, a conductive material is filled into the vias to form the lead-out wires 50 that are led out from the front side of the chip packaging unit 20 and arranged in the prepreg 30 and the conductive layer 40.

In the present disclosure, the chip packaging unit 20 is embedded in the core 10 of the circuit board, and laminated at the bottom of the circuit board, such that structures such as the prepreg 30 and the conductive layer 40 of the circuit board can be used as an insulation layer and a conductor layer for arranging the lead-out wires 50, and a drive circuit arrangement area is reserved on an upper surface of the circuit board to provide space for the arrangement of a drive circuit, such that the formed offset-chip embedded circuit board has a compact overall structure and stable performance, and the consumable cost is significantly reduced.

Further, in some embodiments, prepregs 30 and conductive layers 40 are alternately stacked in a plurality of groups. Stacking a prepreg 30 and a conductive layer 40 on the core 10 and drilling the conductive layer 40 and the prepreg 30 includes:
stacking a first group of prepreg 30 and conductive layer 40 on the core 10, and drilling the first group of conductive layer 40 and prepreg 30 to form first vias that penetrate the first group of conductive layer 40 and prepreg 30 and that communicate with the lead-out areas of the electrodes of the chip unit 22; and
stacking a second group of prepreg 30 and conductive layer 40 on the core 10, and drilling the second group of conductive layer 40 and prepreg 30 to form second vias that penetrate the second group of conductive layer 40 and prepreg 30 and that communicate with the lead-out areas of the electrodes of the chip unit 22 through the first vias.

In addition, the manufacturing method for a circuit board may further include:
providing, on the conductive layer 40, pads 60 electrically connected to the lead-out wires 50, arranging a drive circuit on an upper surface of the offset-chip embedded circuit board, etc. For details, reference may be made to the descriptions of the embodiments of the foregoing offset-chip embedded circuit board, which will not be repeated here.

The above is a further detailed description of the present disclosure with reference to the specific preferred implementations, and it cannot be considered that the specific implementation of the present disclosure is limited to these descriptions. For those of ordinary skill in the art of the present disclosure, several simple deductions or substitutions can be further made without departing from the concept of the present disclosure, and should be regarded as falling within the scope of protection of the present disclosure.

## Claims

1. An offset-chip embedded circuit board, comprising:
a core;
a chip packaging unit embedded in the core, the chip packaging unit comprising a conductive substrate and a chip unit embedded in the conductive substrate, wherein the chip unit is offset on a side of the conductive substrate, and an electrode lead-out area of the chip unit is reserved on the other side of the conductive substrate;
a prepreg and a conductive layer stacked on the core; and
lead-out wires led out from a front side of the chip packaging unit and arranged in the prepreg and the conductive layer.

2. The offset-chip embedded circuit board according to claim 1, wherein a gate lead-out area, a source lead-out area, and a drain lead-out area of the chip unit are all distributed on the front side of the chip packaging unit; and
the lead-out wires comprise gate lead-out wires connected to the gate lead-out area, source lead-out wires connected to the source lead-out area, and drain lead-out wires connected to the drain lead-out area.

3. The offset-chip embedded circuit board according to claim 2, wherein a gate and a source of the chip unit are located on a front side of the chip unit, and a drain of the chip unit is located on a back side of the chip unit; and
the electrode lead-out area reserved on the conductive substrate is the drain lead-out area, and the gate lead-out area and the source lead-out area are located on the chip unit.

4. The offset-chip embedded circuit board according to claim 3, wherein an effective area of the drain lead-out area matches an effective area of the source lead-out area.

5. The offset-chip embedded circuit board according to claim 2, wherein the source lead-out wires and the drain lead-out wires are both arranged in a grid-like manner.

6. The offset-chip embedded circuit board according to claim 1, further comprising:
pads disposed on the conductive layer and electrically connected to the lead-out wires.

7. The offset-chip embedded circuit board according to claim 1, wherein an entire upper surface of the offset-chip embedded circuit board forms a drive circuit arrangement area.

8. The offset-chip embedded circuit board according to any one of claims 1-7, wherein the chip packaging unit is a power module of an inverter; and
a plurality of chip units are embedded in the core, wherein a drain lead-out wire of a chip unit of an upper bridge arm is connected to a positive electrode of a power source, a source lead-out wire of a chip unit of a lower bridge arm is connected to a negative electrode of the power source, a source lead-out wire of the chip unit of the upper bridge arm is connected to a drain lead-out wire of the chip unit of the lower bridge arm and to a winding of an electric motor, and a gate lead-out wire of the chip unit of the upper bridge arm and the drain lead-out wire of the chip unit of the lower bridge arm are connected to a drive circuit arranged on the upper surface of the embedded circuit board.

9. A manufacturing method for a circuit board for manufacturing an offset-chip embedded circuit board according to any one of claims 1-8, the manufacturing method comprising:
forming a slot in a core;
embedding a chip packaging unit in the slot, the chip packaging unit comprising a conductive substrate and a chip unit embedded in the conductive substrate, wherein the chip unit is offset on a side of the conductive substrate, and an electrode lead-out area of the chip unit is reserved on the other side of the conductive substrate;
stacking a prepreg and a conductive layer on the core, and drilling the conductive layer and the prepreg to form vias that penetrate the conductive layer and the prepreg and that communicate with lead-out areas of electrodes of the chip unit; and
filling a conductive material into the vias to form lead-out wires that are led out from a front side of the chip packaging unit and arranged in the prepreg and the conductive layer.

10. The manufacturing method according to claim 9, wherein prepregs and conductive layers are alternately stacked in a plurality of groups; and
stacking a prepreg and a conductive layer on the core and drilling the conductive layer and the prepreg comprises:
stacking a first prepreg and a first conductive layer on the core, and drilling the first conductive layer and the first prepreg to form first vias that penetrate the first conductive layer and the first prepreg and that communicate with the lead-out areas of the electrodes of the chip unit; and
stacking a second prepreg and a second conductive layer on the first conductive layer, and drilling the second conductive layer and the second prepreg to form second vias that penetrate the second conductive layer and the second prepreg and that communicate with the lead-out areas of the electrodes of the chip unit through the first vias.
